# FASCICULE DE BREVET EUROPEEN

(11) **EP 3 024 801 B1**
(45) Date de publication et mention de la délivrance du brevet: **25.09.2019**
(21) Numéro de dépôt: 14750567.1
(22) Date de dépôt: 15.07.2014
(51) Int. Cl.: C04B 35/573, C04B 35/80, C04B 35/628, C22C 47/06, C22C 47/08, C22C 49/14

(54) **PROCÉDÉ DE FABRICATION DE PIÈCES EN MATÉRIAU COMPOSITE PAR IMPRÉGNATION A BASSE TEMPÉRATURE DE FUSION**
VERFAHREN ZUR HERSTELLUNG VON VERBUNDTEILEN DURCH IMPRÄGNIERUNG MIT NIEDRIGEM SCHMELZPUNKT
PROCESS FOR FABRICATING COMPOSITE PARTS BY LOW MELTING POINT IMPREGNATION

(30) Priorité: 23.07.2013 FR 1357238
(43) Date de publication de la demande: 01.06.2016
(73) Titulaire: Safran Ceramics, 33185 Le Haillan (FR)
(72) Inventeur: PHILIPPE, Eric, F-33700 Merignac (FR); BOUILLON, Eric, F-33185 Le Haillan (FR); COURCOT, Emilie, F-33320 Le Taillan (FR); JIMENEZ, Sébastien, F-33000 Bordeaux (FR)
(74) Mandataire: Laïk, Eric
(86) Numéro de dépôt international: PCT/FR2014/051821
(87) Numéro de publication internationale: WO 2015/011371

(56) Documents cités:
- WO-A1-01/07377
- WO-A1-2010/063946
- FR-A1- 2 851 244
- FR-A1- 2 983 193

## Description

### Arrière-plan de l'invention

L'invention concerne les compositions d'infiltration utilisées dans la réalisation de pièces en matériau composite à matrice céramique ou au moins partiellement en céramique, désigné ci-après par matériau CMC et de pièces en matériau composite carbone/carbone (C/C).

Un domaine d'application de l'invention est la réalisation de pièces destinées à être exposées en service à des températures élevées, notamment dans des domaines aéronautique et spatial, en particulier des pièces de parties chaudes de turbomachines aéronautiques, étant noté que l'invention peut être appliquée dans d'autres domaines, par exemple le domaine des turbines à gaz industrielles.

Les matériaux composites CMC et C/C possèdent des bonnes propriétés thermostructurales, c'est-à-dire des propriétés mécaniques élevées qui les rendent aptes à constituer des pièces structurales et la capacité de conserver ces propriétés à hautes températures.

L'utilisation de matériaux CMC ou C/C à la place de matériaux métalliques pour des pièces exposées en service à des températures élevées a donc été préconisée, d'autant que les matériaux CMC et C/C présentent une masse volumique sensiblement plus faible que les matériaux métalliques auxquels ils se substituent.

Un procédé bien connu pour la fabrication de pièces en matériau CMC consiste à réaliser une préforme à partir de strates fibreuses de fibres de carbone ou de carbure de silicium (SiC) et à infiltrer la préforme avec une composition à base de silicium fondu de manière à former une matrice céramique. Un tel processus de densification est connu sous la désignation processus MI ("Melt Infiltration"). On pourra se référer par exemple aux documents FR 983 193, US 4 889 686, US 4 944 904 ou US 5 015 540. La composition d'infiltration est principalement à base de silicium car cet élément présente un coefficient de dilatation thermique proche de celui des fibres de la préforme. La composition d'infiltration peut correspondre à du silicium seul ou à un alliage de silicium contenant généralement une faible proportion d'un ou plusieurs autres éléments tels que du titane, du molybdène, du bore, du fer, du niobium, etc.

La densification par processus MI présente l'avantage d'être bien plus rapide et aisée à mettre en oeuvre que la densification par infiltration chimique en phase vapeur (CVI). Toutefois, la composition d'infiltration à base de silicium utilisée peut présenter un point ou une température de fusion supérieur à la température de stabilité thermique des fibres de la préformes (thermostabilité). Dans ce cas, les fibres peuvent subir une dégradation lors de l'infiltration de la composition fondue dans la préforme qui peut réduire considérablement les propriétés mécaniques des fibres.

Le document FR 2 851 244 divulgue entre autres un matériau SiC/SiC produit par infiltration d'un renfort fibreux à l'aide d'une composition en fusion de silicium et de germanium dans des proportions 50/50 atomiques, dont la température de liquidus est d'environ 1250°C.

Le document WO 2010/63946 décrit un procédé de lissage de surface d'une pièce CMC présentant une surface ondulée et rugueuse.

### Objet et résumé de l'invention

L'invention a notamment pour but de fournir un procédé de fabrication de pièce en matériau composite ne présentant pas les inconvénients précités.

Ce but est atteint grâce à un procédé de fabrication d'une pièce en matériau composite, comprenant les étapes de :
- réalisation d'une préforme fibreuse consolidée, les fibres de la préforme étant des fibres de carbone ou de céramique et étant revêtues d'une interphase,
- obtention d'une préforme fibreuse consolidée et partiellement densifiée, la densification partielle comprenant la formation sur l'interphase d'une première phase de matrice obtenue par infiltration chimique en phase gazeuse, et
- poursuite de la densification par infiltration de la préforme fibreuse avec une composition d'infiltration contenant au moins du silicium et au moins un autre élément apte à abaisser la température de fusion de la composition d'infiltration à une température inférieure ou égale à 1150°C. En effet, en ajoutant au silicium un élément permettant d'avoir une composition d'infiltration qui présente un point de fusion inférieure ou égale à 1150°C, on dispose d'une composition d'infiltration qui reste dans le domaine de température de stabilité thermique de la plupart des fibres, en particulier des fibres céramiques utilisées pour la réalisation d'un renfort fibreux d'un matériau CMC. Ainsi, le procédé de fabrication d'une pièce en matériau composite de l'invention utilisant un processus de densification de type MI peut être mis en oeuvre sans risque d'endommagement des fibres de la préforme.

Selon l'invention, la composition d'infiltration comprend du nickel, la proportion en masse de nickel dans ladite composition étant comprise entre 50% et 75%. Avec une proportion de nickel comprise entre 50% et 75% en outre du silicium, on obtient une composition d'infiltration dont le point de fusion est inférieur ou égal à 1150°C.

Selon un aspect du procédé ne faisant pas partie de l'invention, la composition d'infiltration comprend du germanium, la proportion en masse de germanium dans ladite composition étant comprise entre 89% et 98%. Avec au moins 89% de germanium en outre du silicium, on obtient une composition d'infiltration dont le point de fusion est inférieur ou égal à 1150°C.

Selon un premier aspect du procédé de l'invention, la composition d'infiltration contient, en outre de l'élément apte à abaisser la température de fusion de la composition d'infiltration à une température inférieure ou égale à 1150°C, moins de 10% (pourcentage massique) d'au moins un des éléments suivants : aluminium et bore. L'ajout d'au moins un de ces constituants permet d'améliorer la désoxydation et/ou la mouillabilité de la composition d'infiltration sur le substrat à traiter ainsi que de conférer des propriétés particulières au matériau traité comme une tenue améliorée vis-à-vis de l'oxydation et de la corrosion.

Selon un deuxième aspect du procédé de l'invention, la préforme fibreuse est formée à partir de fibres de carbone ou de carbure de silicium (SiC).

Selon un troisième aspect du procédé de l'invention, la préforme fibreuse est formée par une structure fibreuse réalisée en une seule pièce par tissage tridimensionnel ou multicouche ou à partir d'une pluralité de strates fibreuses bidimensionnelles.

Selon un quatrième aspect du procédé de l'invention, l'interphase est formée par au moins une couche d'un des matériaux suivants : carbone pyrolytique (PyC), carbone dopé au bore (BC), nitrure de bore (BN).

L'interphase en PyC, BC ou BN a ici une fonction classique de défragilisation du matériau composite du fait de la structure en feuillets du PyC, BC, ou BN qui favorise la déviation de fissures parvenant à l'interphase après s'être propagées dans la matrice, empêchant ou retardant la rupture de fibres par de telles fissures.

Par carbone dopé au bore, ou BC, on entend une composition contenant 5%at B à 20%at B, le reste étant du carbone. Une telle composition présente une structure turbostratique, c'est-à-dire une désorientation entre feuillets empilés, qui est favorable à la fonction de défragilisation.

Selon un cinquième aspect du procédé de l'invention, la première phase de matrice comprend au moins une couche d'un matériau choisi parmi au moins un des matériaux suivants : matériau autocicatrisant, nitrure de silicium (Si₃N₄) et carbure de silicium (SiC). Le matériau autocicatrisant est choisi parmi un système ternaire Si-B-C et du carbure de bore B₄C.

La première couche de matrice peut comprendre plusieurs couches de matériau autocicatrisant alternant avec une ou plusieurs couches d'un matériau choisi parmi du carbone pyrolytique (PyC), du carbone dopé au bore (BC) et un matériau céramique ne contenant pas de bore.

Selon un mode de mise en oeuvre du procédé, la première phase de matrice est formée avec une couche unique de matériau autocicatrisant ou avec plusieurs couches de matériau autocicatrisant et comprend au moins une couche de matériau céramique ne contenant pas de bore qui est formée sur la couche unique ou la dernière couche de matériau autocicatrisant.

Ladite couche de matériau céramique ne contenant pas de bore peut avoir une épaisseur au moins égale à 500 nanomètres.

Ladite couche de matériau céramique ne contenant pas de bore peut être en carbure de silicium (SiC) ou encore en nitrure de silicium (Si₃N₄).

Selon un sixième aspect du procédé de l'invention, celui-ci comprend, après la densification partielle de la préforme fibreuse et avant la densification par infiltration de la préforme fibreuse avec une composition d'infiltration, une étape de modification du réseau de porosités au sein de la préforme fibreuse réalisée au moyen d'un des traitements suivants :
- dispersion au sein de la préforme de poudre d'au moins un des matériaux suivants : carbure de silicium (SiC), nitrure de silicium (Si₃N₄), carbone (C), bore (B), carbure de bore (B₄C) et carbure de titane (TiC),
- introduction au sein de la préforme d'une phase céramique ou carbone par imprégnation de ladite préforme avec un polymère et pyrolyse dudit polymère,
- introduction au sein de la préforme d'une mousse de carbone ou de céramique par imprégnation de ladite préforme avec un polymère et pyrolyse dudit polymère.

### Brève description des dessins

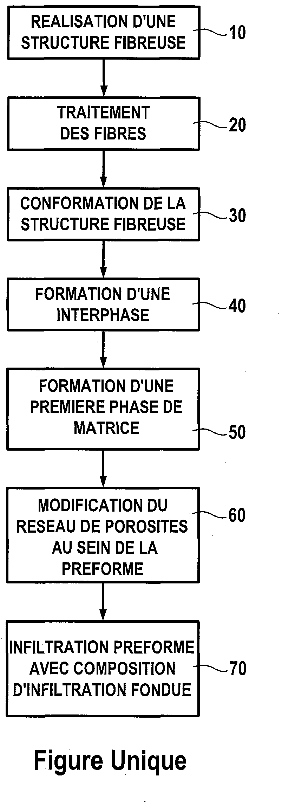

L'invention sera mieux comprise à la lecture de la description faite ci-après, à titre indicatif mais non limitatif, en référence à la figure unique qui montre des étapes successives d'un procédé de fabrication de pièce en matériau CMC selon un mode de réalisation de l'invention.

### Description détaillée de modes de réalisation

L'invention propose un procédé de fabrication de pièces en matériau composite, en particulier des matériaux composites thermostructuraux à matrice céramique (CMC), c'est-à-dire à des matériaux formés d'un renfort en fibres de carbone ou céramique densifié par une matrice au moins partiellement céramique mais également des matériaux composites thermostructuraux carbone/carbone (C/C), c'est-à-dire des matériaux formés d'un renfort en fibres de carbone densifié par une matrice carbone.

Le procédé de fabrication de l'invention est remarquable en ce qu'il utilise une composition d'infiltration qui présente une température de fusion inférieure à celle des compositions d'infiltration à base de silicium habituellement utilisées pour densifier les préformes fibreuses. Plus particulièrement, la composition d'infiltration utilisée dans l'invention permet d'infiltrer des préformes fibreuses avec une composition fondue à une température inférieure à la température de stabilité thermique des fibres (thermostabilité), c'est-à-dire à une température suffisamment basse pour éviter toute dégradation des propriétés mécaniques des fibres de la préforme lors de son infiltration, comme c'est le cas en particulier pour les fibres SiC de première génération. Conformément à l'invention, la préforme fibreuse est infiltrée avec une composition d'infiltration qui est fondue à une température inférieure ou égale 1150°C.

A cet effet, la composition d'infiltration contient, en outre du silicium, au moins un autre élément apte à abaisser la température ou point de fusion de la composition à une température inférieure ou égale à 1150°C. Cet abaissement du point de fusion de la composition d'infiltration est notamment obtenu en ajoutant au silicium du nickel (Ni). Plus précisément, la composition d'infiltration contient entre 50% et 75% (pourcentages massiques) de nickel, ce qui permet d'obtenir un point de fusion compris entre 1000°C (composition d'infiltration contenant 50% de Si et 50% de Ni) et 1150°C (composition d'infiltration contenant 25% de Si et 75% de Ni). Dans le cas de l'ajout de germanium, la composition d'infiltration contient entre 89% et 98% de germanium, ce qui permet d'obtenir un point de fusion compris entre 1000°C (composition d'infiltration contenant 2% de Si et 98% de Ge) et 1150°C (composition d'infiltration contenant 11% de Si et 89% de Ge). Ainsi, en ajoutant une proportion de nickel comprise entre 50% et 75% ou au moins 89% de germanium au silicium, on obtient un alliage de silicium qui présente une température de fusion inférieure ou égale à 1150°C qui est une température inférieure à la température de stabilité thermique des fibres de carbure de silicium SiC (désignées ci-après fibres SiC) comme par exemple des fibres SiC de type Tyranno ZMI®, Tyranno Lox-M® ou Nicalon® de première génération.

En outre d'un point de fusion plus bas, la composition d'infiltration présente toutes les autres propriétés requises pour permettre la fabrication d'un matériau composite de bonne qualité. En effet, la composition d'infiltration est compatible chimiquement avec les éléments présents dans la préforme à infiltrer. La composition d'infiltration présente en outre une bonne résistance vis-à-vis des environnements oxydants ou corrosifs et une excellente tenue dans le temps.

La composition d'infiltration peut contenir en outre moins de 10% (pourcentage massique) d'au moins un des éléments suivants : aluminium et bore. L'ajout d'au moins un de ces constituants permet d'améliorer la désoxydation et/ou la mouillabilité de la composition d'infiltration sur le substrat à traiter ainsi que de conférer des propriétés particulières au matériau traité comme une tenue améliorée vis-à-vis de l'oxydation et de la corrosion.

Un premier mode de réalisation d'un matériau CMC conforme au procédé de l'invention sera décrit en référence à la figure unique.

Une première étape 10 consiste à réaliser une structure fibreuse à partir de laquelle une préforme fibreuse ayant une forme voisine de celle d'une pièce à fabriquer sera réalisée. Une telle structure fibreuse peut être obtenue par tissage multicouches ou tridimensionnel à partir de fils ou câbles. Il est possible aussi de partir de textures fibreuses bidimensionnelles telles que des tissus ou des nappes de fils ou câbles pour former des strates qui seront ensuite drapées sur une forme et éventuellement liées entre elles par exemple par couture ou implantation de fils.

Les fibres constitutives de la structure fibreuse sont de préférence des fibres en céramique, par exemple des fibres formées essentiellement de carbure de silicium SiC (désignées ci-après fibres SiC) ou de nitrure de silicium Si₃N₄. On peut notamment utiliser des fibres SiC commercialisées sous les dénominations « Tyranno ZMI », « Tyranno Lox-M » et « Tyranno SA3 » par la société japonais Ube Industries, Ltd ou « Nicalon », « Hi-Nicalon » et « Hi-Nicalon(S) » par la société japonaise Nippon Carbon. Il est possible en variante d'utiliser des fibres de carbone.

De façon connue, dans le cas de fibres en céramique, notamment de fibres SiC, un traitement de surface de celles-ci préalablement à la formation d'un revêtement d'interphase est de préférence réalisé (étape 20) pour éliminer l'ensimage et une couche superficielle d'oxyde tel que de la silice SiO₂ présents sur les fibres.

L'étape 30 consiste à conformer la structure fibreuse au moyen d'un outillage pour obtenir une préforme ayant une forme voisine de celle de la pièce à fabriquer.

La préforme étant maintenue dans son outillage de conformation, par exemple en graphite, une interphase de défragilisation est formée par CVI sur les fibres de la préforme, cette interphase étant notamment en carbone pyrolytique ou PyC, ou en nitrure de bore (BN), ou en carbone dopé au bore, ou BC (avec 5%at à 20%at de bore, le reste étant du carbone) (étape 40). L'épaisseur de l'interphase de PyC ou BC est de préférence comprise entre 10 nm et 1000 nm.

Ensuite (étape 50), une première phase de matrice est formée par CVI, la matrice pouvant contenir au moins une couche de matériau autocicatrisant. On peut choisir un matériau autocicatrisant contenant du bore, par exemple un système ternaire Si-B-C ou du carbure de bore B₄C capable de former, en présence d'oxygène, un verre de type borosilicate ayant des propriétés autocicatrisantes. L'épaisseur de la première phase de matrice au moins égale à 500 nm, de préférence comprise entre 1 µm et 30 µm.

La première phase de matrice peut comprendre une couche unique d'un matériau autocicatrisant ou plusieurs couches de matériaux autocicatrisants différents. On peut aussi former la première phase de matrice de plusieurs couches de matériau autocicatrisant alternant avec des couches de PyC ou de BC ou de matériau céramique ne contenant pas de bore, comme par exemple du SiC ou du nitrure de silicium Si₃N₄.

Une couche de matériau céramique ne contenant pas de bore, par exemple SiC ou Si₃N₄, est formée sur la couche de matériau autocicatrisant, lorsque la première phase de matrice ne comprend qu'une seule couche de matériau autocicatrisant, ou sur la dernière couche de matériau autocicatrisant, lorsque la première phase de matrice comprend plusieurs couches de matériau autocicatrisant, pour constituer une barrière de réaction entre le matériau autocicatrisant et le silicium fondu ou la composition liquide à base de silicium introduite ultérieurement.

L'épaisseur de cette couche de matériau céramique formant barrière de réaction peut être au moins égale à 500 nm, typiquement de un à plusieurs microns. Des matériaux céramiques ne contenant pas de bore et autres que SiC ou Si₃N₄ peuvent être utilisés pour former barrière de réaction, par exemple des carbures réfractaires tels que ZrC ou HfC.

L'épaisseur totale de l'interphase et la première phase de matrice est choisie suffisante pour consolider la préforme fibreuse, c'est-à-dire pour lier entre elles les fibres de la préforme de façon suffisante pour que la préforme puisse être manipulée en conservant sa forme sans assistance d'outillage de maintien. Cette épaisseur peut être au moins égale à 500 nm. Après consolidation, la préforme reste poreuse, la porosité initiale n'étant par exemple comblée que pour une partie minoritaire par l'interphase et la première phase de matrice.

La réalisation de dépôts de PyC, BC, B₄C, Si-B-C, Si₃N₄, BN et SiC par CVI est connue. On pourra notamment se référer aux documents US 5 246 736, US 5 738 951, US 5 965 266, US 6 068 930 et US 6 284 358.

On notera que l'étape de formation de l'interphase par CVI pourra être réalisée sur les fibres de la structure fibreuse avant conformation de celle-ci dans la mesure où l'interphase est suffisamment mince pour ne pas affecter la capacité souhaitée de déformation de la structure fibreuse.

La préforme consolidée poreuse est retirée de son outillage de conformation pour poursuivre la densification par un processus de type MI comprenant la modification du réseau de porosités dans la préforme et l'infiltration de celle-ci avec une composition d'infiltration.

La modification du réseau de porosités au sein de la préforme (étape 60) est réalisée au moyen d'un des traitements suivants :
- dispersion au sein de la préforme de poudre d'au moins un des matériaux suivants : carbure de silicium (SiC), nitrure de silicium (Si₃N₄), carbone (C), bore (B), carbure de bore (B₄C) et carbure de titane (TiC),
- introduction au sein de la préforme d'une phase céramique ou carbone par imprégnation de ladite préforme avec un polymère et pyrolyse dudit polymère,
- introduction au sein de la préforme d'une mousse de carbone ou de céramique par imprégnation de ladite préforme avec un polymère et pyrolyse dudit polymère.

Dans l'exemple décrit ici, la modification du réseau de porosités au sein de la préforme est réalisée par dispersion d'une poudre à l'aide d'une composition d'imprégnation. La composition d'imprégnation peut être une barbotine contenant la poudre en suspension dans un véhicule liquide, par exemple de l'eau. La poudre peut être retenue dans la préforme par filtration ou par décantation éventuellement avec l'aide d'une dépression. On utilise de préférence une poudre formée de particules de dimension moyenne inférieure à 5 µm.

Après séchage, on obtient une préforme consolidée dans la porosité de laquelle une poudre de carbone et/ou céramique est dispersée.

La densification est poursuivie (étape 70) par infiltration de la préforme avec une composition d'infiltration, ici une composition contenant 46% (pourcentage massique) de silicium et 54% (pourcentage massique) de nickel, la fusion de la composition étant obtenue à une température d'environ 1000°C. L'infiltration est réalisée sous atmosphère non oxydante, de préférence sous pression réduite.

Dans le cas où la poudre introduite préalablement est en carbone ou si le matériau contient une phase carbone accessible, et dans le cas de présence de résidu carbone d'une résine utilisée pour l'imprégnation de la préforme consolidée, le silicium réagit avec celui-ci pour former du carbure de silicium SiC. Dans le cas où la poudre introduite préalablement est en céramique, notamment carbure, nitrure ou siliciure, et dans le cas de présence de résidu céramique d'une résine utilisée pour l'imprégnation de la préforme consolidée, on obtient une matrice partiellement en silicium liant la poudre céramique. Dans tous les cas, la matrice est majoritairement en céramique.

## Revendications

1. Procédé de fabrication d'une pièce en matériau composite, comprenant les étapes de :
- réalisation d'une préforme fibreuse consolidée, les fibres de la préforme étant des fibres de carbone ou de céramique et étant revêtues d'une interphase,
- obtention d'une préforme fibreuse consolidée et partiellement densifiée, la densification partielle comprenant la formation sur l'interphase d'une première phase de matrice obtenue par infiltration chimique en phase gazeuse, et
- poursuite de la densification par infiltration de la préforme fibreuse avec une composition d'infiltration contenant au moins du silicium et au moins un autre élément apte à abaisser la température de fusion de la composition d'infiltration à une température inférieure ou égale à 1150°C, la composition d'infiltration comprenant du nickel, la proportion en masse de nickel dans ladite composition étant comprise entre 50% et 75%.

2. Procédé selon la revendication 1, caractérisé en que la composition d'infiltration contient, en outre dudit élément apte à abaisser la température de fusion de la composition d'infiltration à une température inférieure ou égale à 1150°C, moins de 10% en masse d'au moins un des éléments suivants : aluminium et bore.

3. Procédé selon l'une quelconque des revendications 1 ou 2, **caractérisé en ce que** la préforme fibreuse est formée à partir de fibres de carbone ou de carbure de silicium (SiC).

4. Procédé selon l'une quelconque des revendications 1 à 3, **caractérisé en ce que** la préforme fibreuse est formée par une structure fibreuse réalisée en une seule pièce par tissage tridimensionnel ou multicouche ou à partir d'une pluralité de strates fibreuses bidimensionnelles.

5. Procédé selon l'une quelconque des revendications 1 à 4, **caractérisé en ce que** l'interphase est formée par au moins une couche d'un des matériaux suivants : carbone pyrolytique (PyC), carbone dopé au bore (BC), nitrure de bore (BN).

6. Procédé selon la revendication 5, **caractérisé en ce que** la première phase de matrice comprend au moins une couche d'un matériau choisi parmi au moins un des matériaux suivants : matériau autocicatrisant, nitrure de silicium (Si₃N₄) et carbure de silicium (SiC).

7. Procédé selon la revendication 6, **caractérisé en ce que** la première phase de matrice comprend au moins une couche de matériau autocicatrisant choisi parmi un système ternaire Si-B-C et du carbure de bore B₄C.

8. Procédé selon l'une quelconque des revendications 1 à 7, **caractérisé en ce que** la première phase de matrice comprend plusieurs couches de matériau autocicatrisant alternant avec une ou plusieurs couches d'un matériau choisi parmi du carbone pyrolytique (PyC), du carbone dopé au bore (BC) et un matériau céramique ne contenant pas de bore.

9. Procédé selon l'une quelconque des revendications 1 à 8, **caractérisé en ce qu'**il comprend, après la densification partielle de la préforme fibreuse et avant la densification par infiltration de la préforme fibreuse avec une composition d'infiltration, une étape de modification du réseau de porosités au sein de la préforme fibreuse réalisée au moyen d'un des traitements suivants :
- dispersion au sein de la préforme de poudre d'au moins un des matériaux suivants : carbure de silicium (SiC), nitrure de silicium (Si₃N₄), carbone (C), bore (B), carbure de bore (B4C) et carbure de titane (TiC),
- introduction au sein de la préforme d'une phase céramique ou carbone par imprégnation de ladite préforme avec un polymère et pyrolyse dudit polymère,
- introduction au sein de la préforme d'une mousse de carbone ou de céramique par imprégnation de ladite préforme avec un polymère et pyrolyse dudit polymère.

## Patentansprüche

1. Verfahren zur Herstellung eines Verbundmaterialteils, umfassend die folgenden Schritte:
- Herstellen einer konsolidierten faserigen Vorform, wobei es sich bei den Fasern der Vorform um Kohlenstoff- oder Keramikfasern handelt und diese mit einer Zwischenphase beschichtet sind,
- Erhalten einer konsolidierten und teilweise verdichteten faserigen Vorform, wobei die teilweise Verdichtung das Bilden einer ersten Matrixphase auf der Zwischenphase umfasst, die durch chemische Infiltration in der Gasphase erhalten wurde, und
- Fortsetzen der Verdichtung der faserigen Vorform durch Infiltration mit einer Infiltrationszusammensetzung, die mindestens Silicium und mindestens ein weiteres Element enthält, das geeignet ist, die Schmelztemperatur der Infiltrationszusammensetzung auf eine Temperatur von weniger als oder gleich 1150 °C zu senken, wobei die Infiltrationszusammensetzung Nickel umfasst, wobei der Gewichtsanteil von Nickel in der Zusammensetzung zwischen 50 % und 75 % liegt.

2. Verfahren nach Anspruch 1, **dadurch gekennzeichnet, dass** die Infiltrationszusammensetzung neben dem besagten Element, das in der Lage ist, die Schmelztemperatur der Infiltrationszusammensetzung auf eine Temperatur von weniger als oder gleich 1150 °C senken, weniger als 10 Gew.-% von mindestens einem der folgenden Elemente enthält: Aluminium und Bor.

3. Verfahren nach einem der Ansprüche 1 oder 2, **dadurch gekennzeichnet, dass** die faserige Vorform aus Fasern von Kohlenstoff oder Siliciumcarbid (SiC) gebildet wird.

4. Verfahren nach einem der Ansprüche 1 bis 3, **dadurch gekennzeichnet, dass** die faserige Vorform durch eine faserige Struktur gebildet wird, die einteilig durch dreidimensionales oder mehrschichtiges Weben oder aus einer Vielzahl von zweidimensionalen faserigen Schichten gebildet wird.

5. Verfahren nach einem der Ansprüche 1 bis 4, **dadurch gekennzeichnet, dass** die Zwischenphase durch mindestens eine Schicht aus einem der folgenden Materialien gebildet wird: pyrolytischer Kohlenstoff (PyC), bordotierter Kohlenstoff (BC), Bornitrid (BN).

6. Verfahren nach Anspruch 5, **dadurch gekennzeichnet, dass** die erste Matrixphase mindestens eine Schicht aus einem Material umfasst, das aus mindestens einem der folgenden Materialien ausgewählt ist: selbstheilendes Material, Siliciumnitrid (Si₃N₄) und Siliciumcarbid (SiC).

7. Verfahren nach Anspruch 6, **dadurch gekennzeichnet, dass** die erste Matrixphase mindestens eine Schicht aus selbstheilendem Material umfasst, ausgewählt aus einem ternären Si-B-C-System und Borcarbid B₄C.

8. Verfahren nach einem der Ansprüche 1 bis 7, **dadurch gekennzeichnet, dass** die erste Matrixphase eine Vielzahl von Schichten aus selbstheilendem Material umfasst, die sich mit einer oder mehreren Schichten aus einem Material abwechseln, das ausgewählt ist aus pyrolytischem Kohlenstoff (PyC), bordotiertem Kohlenstoff (BC) und einem borfreien Keramikmaterial.

9. Verfahren nach einem der Ansprüche 1 bis 8, **dadurch gekennzeichnet, dass** es nach dem teilweisen Verdichten der faserigen Vorform und vor dem Verdichten der faserigen Vorform durch Infiltration mit einer Infiltrationszusammensetzung einen Schritt des Modifizierens des Porositätsnetzes innerhalb der faserigen Vorform umfasst, der mittels einer der folgenden Behandlungen durchgeführt wird:
- Dispergieren von Pulver aus mindestens einem der folgenden Materialien in der Vorform: Siliciumcarbid (SiC), Siliciumnitrid (Si₃N₄), Kohlenstoff (C), Bor (B), Borcarbid (B₄C) und Titancarbid (TiC),
- Einbringen einer Keramik- oder Kohlenstoffphase in die Vorform durch Imprägnieren der Vorform mit einem Polymer und Pyrolyse des Polymers,
- Einbringen eines Kohlenstoff- oder Keramikschaums in die Vorform durch Imprägnieren der Vorform mit einem Polymer und Pyrolyse des Polymers.

## Claims

1. A method of fabricating a composite material part, the method comprising the steps of:
• making a consolidated fiber preform, the fibers of the preform being carbon or ceramic fibers and being coated with an interphase;
• obtaining a consolidated and partially densified fiber preform, the partial densification comprising using chemical vapor infiltration to form a first matrix phase on the interphase; and
• continuing densification of the fiber preform by infiltrating an infiltration composition containing at least silicon and at least one other element suitable for lowering the melting temperature of the infiltration composition to a temperature less than or equal to 1150°C, the infiltration composition includes nickel, the proportion by weight of nickel in said composition lying in the range 50% to 75%.

2. A method according to claim 1, **characterized in that** the infiltration composition includes, in addition to said element suitable for reducing the melting temperature of the infiltration composition to a temperature less than or equal to 1150°C, less than 10% by weight of at least one of the following elements: aluminum and boron.

3. A method according to any one of claims 1 or 2, **characterized in that** the fiber preform is made of carbon fibers or of silicon carbide (SiC) fibers.

4. A method according to any one of claims 1 to 3, **characterized in that** the fiber preform is formed as a fiber structure made as a single part by three-dimensional or multilayer weaving or from a plurality of two-dimensional fiber plies.

5. A method according to any one of claims 1 to 4, **characterized in that** the interphase is formed by at least one layer of any one of the following materials: pyrolytic carbon (PyC), boron-doped carbon (BC), and boron nitride (BN).

6. A method according to claim 5, **characterized in that** the first matrix phase comprises at least one layer of a material selected from at least one of the following materials: a self-healing material, silicon nitride (Si₃N₄), and silicon carbide (SiC).

7. A method according to claim 6, **characterized in that** the first matrix phase includes at least one layer of self-healing material selected from a ternary Si-B-C system and boron carbide B₄C.

8. A method according to any one of claims 1 to 7, **characterized in that** the first matrix phase comprises a plurality of layers of self-healing material alternating with one or more layers of material selected from pyrolytic carbon (PyC), boron-doped carbon (BC), and a ceramic material that does not contain boron.

9. A method according to any one of claims 1 to 8, **characterized in that**, after partial densification of the fiber preform and before densification of the fiber preform by infiltration with an infiltration composition, it includes a step of modifying the array of pores within the fiber preform, which modification is performed by means of any one of the following treatments:
• dispersing a powder of at least one of the following materials within the preform: silicon carbide (SiC) ; silicon nitride (Si₃N₄) ; carbon (C) ; boron (B) ; boron carbide (B₄C); and titanium carbide (TiC);
• introducing a ceramic or a carbon phase within the preform by impregnating said preform with a polymer, and pyrolyzing said polymer; or
• introducing a carbon or ceramic foam within the preform by impregnating said preform with a polymer, and pyrolyzing said polymer.
